(19) Europäisches Patentamt
European Patent Office
Office européen des brevets

(11) **EP 2 842 007 B2**

(12) **NOUVEAU FASCICULE DE BREVET EUROPEEN**
Après la procédure d'opposition

(45) Date de publication et mention de la décision concernant l'opposition:
**11.09.2024   Bulletin 2024/37**

(45) Mention de la délivrance du brevet:
**24.08.2016   Bulletin 2016/34**

(21) Numéro de dépôt: 13723849.9

(22) Date de dépôt: **22.04.2013**

(51) Classification Internationale des Brevets (IPC):
*G05B 19/4099* *(2006.01)*

(52) Classification Coopérative des Brevets (CPC):
**G05B 19/4099;** G05B 2219/35128;
G05B 2219/45147

(86) Numéro de dépôt international:
**PCT/FR2013/050891**

(87) Numéro de publication internationale:
**WO 2013/160601 (31.10.2013 Gazette 2013/44)**

(54) **PROCEDE D'USINAGE DU BORD DE FUITE D'UNE AUBE DE TURBOMACHINE**

VERFAHREN ZUR BEARBEITUNG DER ABSTRÖMKANTE EINER TURBINENMOTORSCHAUFEL

METHOD FOR MACHINING THE TRAILING EDGE OF A TURBINE ENGINE BLADE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **24.04.2012  FR 1253764**

(43) Date de publication de la demande:
**04.03.2015   Bulletin 2015/10**

(73) Titulaire: **Safran Aircraft Engines**
**75015 Paris (FR)**

(72) Inventeurs:
• **LOUESDON, Yvon, Marie-Joseph**
**77550 Moissy-Cramayel cedex (FR)**
• **LE MERDI, Florian**
**77550 Moissy-Cramayel cedex (FR)**

• **TAMI, Joseph**
**77550 Moissy-Cramayel cedex (FR)**
• **QUACH, Daniel**
**77550 Moissy-Cramayel cedex (FR)**
• **CISSE, Fadoua**
**77550 Moissy-Cramayel cedex (FR)**
• **MALTAVERNE, Sabine**
**77550 Moissy-Cramayel cedex (FR)**
• **ALQUIER, Damien**
**77550 Moissy-Cramayel cedex (FR)**

(74) Mandataire: **Gevers & Orès**
**Immeuble le Palatin 2**
**3 Cours du Triangle**
**CS 80165**
**92939 Paris La Défense Cedex (FR)**

(56) Documents cités:
**FR-A1- 2 913 901     US-A1- 2009 144 980**

EP 2 842 007 B2

**Description**

Domaine technique

La présente invention concerne la fabrication d'aubes de turbomachines et plus particulièrement le domaine de l'usinage de finition de telles pièces par exemple issues de la fonderie.

Exposé du problème

L'amélioration des performances des moteurs à turbine à gaz passe par la réalisation d'aubages au profil aérodynamique optimisé. En particulier on cherche à obtenir des aubes présentant un bord de fuite, BF, d'épaisseur aussi faible que possible compte tenu de contraintes de tenue mécanique et de fabrication. Ainsi, dans le domaine aéronautique, pour un moteur à turbine à gaz à double corps, tel qu'un turboréacteur multiflux, un objectif est la fabrication d'aubes mobiles pour les étages de la turbine à basse pression dont l'épaisseur du bord de fuite est aussi faible que 0,2 mm. Pour les aubes formant les distributeurs des étages à basse pression, l'épaisseur visée est 0,5 mm.

Les aubages mentionnés ci-dessus sont généralement fabriqués par fonderie et coulée de métal dans un moule selon la technique dite à la cire perdue qui permet d'obtenir directement la forme souhaitée de la pale sans passer par la mise en oeuvre d'étapes d'usinage pour parvenir à la pièce finie.

Cependant, les procédés de fonderie en l'état actuel de la technique ne permettent pas d'obtenir des aubages avec des bords de fuite aussi fins. Par fonderie, on obtient au mieux des aubages ayant une épaisseur de bord de fuite de l'ordre de 0,7 mm pour les alliages à base nickel ou cobalt.

Ainsi, face aux besoins en amélioration des performances aérodynamiques des turbomachines, les techniques de fonderie ont atteint leurs limites quant à la finesse des bords de fuite. Un usinage complémentaire est nécessaire.

Cependant un simple usinage du bord de fuite de manière à réduire son épaisseur ne permettrait pas de parvenir à la finesse souhaitée car les pièces brutes issues de fonderie - ainsi que cela l'a été révélé par des mesures sans contact des épaisseurs - présentent des déformations le long du bord de fuite de la pale. L'examen de ces déformations a permis de constater qu'elles présentent une forme comparable à celle qui résulterait d'un flambage de la pale. Le document FR-A1-2 913 901 divulgue un procédé de fabrication d'une aube de turbomachine selon l'état de la technique.

Partant de ces constatations, la demanderesse s'est fixé comme objectif la mise au point d'un procédé permettant de fabriquer des aubages de turbomachine dont la finesse du bord de fuite satisfait aux exigences actuelles d'amélioration de leurs performances aérodynamiques.

Exposé de l'invention

La présente invention parvient à la réalisation de cet objectif avec un procédé tel que défini à la revendication 1.

Le procédé de l'invention permet d'effectuer les opérations de finition sur une machine outil à commande numérique assurant une grande précision de l'usinage et un profil satisfaisant aux contraintes aérodynamiques. En particulier aucun ressaut n'apparaît, sur la face traitée entre la portion de surface usinée et la surface adjacente. L'usinage est dit adaptatif car la trajectoire de l'outil d'usinage s'adapte à la géométrie de la pièce en cours d'usinage.

Conformément à l'invention, la surépaisseur à usiner est ménagée sur l'extrados, sur l'intrados et/ou sur la corde. En particulier une première surépaisseur est éliminée sur l'extrados qui constitue la première face. Lorsque la surépaisseur s'étend sur les deux faces, on extrapole le fait que la valeur de la déformation de la pale à l'intrados est similaire à celle de l'extrados mais de sens opposé. On utilise ainsi la correction mesurée en chaque point de la première face, pour déterminer la correction à usiner sur la face opposée. Cette correction est égale en valeur et opposée en direction.

Enfin on réduit, le cas échéant, la corde de l'aube le long du bord de fuite pour parvenir au profil du bord de fuite de l'épaisseur souhaitée.

Le nombre de points palpés est au minimum de trois. Ils sont répartis entre les deux plateformes pour un secteur de distributeur ou entre la plateforme du pied et le sommet de la pale pour une aube mobile ils sont disposés parallèlement au bord de fuite. Notamment les sommets des carreaux d'usinage comprennent les points palpés et des points dont la position s'en déduit par translation le long de la corde passant par les points palpés.

L'usinage est effectué de préférence par un fraisage en roulant, c'est-à-dire que la matière est enlevée par la paroi périphérique coupante d'un outil cylindrique et non par l'extrémité distale de celui-ci.

D'autres moyens d'usinage entrent dans le cadre du procédé de l'invention. Par exemple il peut s'agir d'un polissage adaptatif par bande au moyen d'une machine de polissage ou robot de polissage. Il peut s'agir d'un usinage adaptatif par meulage ou rectification. Il peut s'agir encore d'un usinage par robot de fraisage et non par machine outil. Plus généralement l'invention couvre tout procédé et outil d'enlèvement de matière adaptatif.

Conformément à une autre caractéristique et selon un mode de réalisation avantageux, le procédé comprend le montage de l'aubage sur un support amovible et le montage du support amovible sur une machine outil à commande numérique avec un trièdre d'usinage, l'usinage étant effectué avec enlèvement de matière selon une composante des 3 axes du trièdre d'usinage.

Plus particulièrement, selon une première application, l'aubage étant une aube mobile de turbine, l'aubage est fixé sur le support amovible en étant serré entre un mors amovible et un mors fixe de manière à former un ensemble rigide. Le mors fixe est conformé au profil théorique d'une face de la pale, de préférence son extrados, tout en laissant libre le bord de fuite à usiner. La pièce est serrée sur la plus grande surface possible afin de réduire les vibrations tout en maintenant l'accessibilité d'une part au palpeur pour les mesures puis, d'autre part, aux outils pour l'usinage.

Selon une seconde application, l'aubage faisant partie d'un secteur de distributeur de turbine, le support amovible est agencé pour un montage isostatique du secteur dans le support amovible. Le montage est isostatique car il bloque les six degrés de liberté de la pièce (3 translations et 3 rotations). Il reprend des points d'appui identiques à ceux utilisés pour l'opération de contrôle après usinage. Conformément à une autre caractéristique, le support amovible comprend un moyen pour amortir les vibrations produites lors de l'usinage.

Selon cette seconde application, l'usinage de chacune des aubes du secteur de distributeur comprend une étape préalable de recalage au mieux de l'aube par rapport au trièdre d'usinage sur la machine outil.

Le présent document décrit également un support amovible pour la mise en oeuvre du procédé, l'aubage étant une aube mobile de turbine.

Le support d'usinage d'une aube mobile de turbomachine comprenant une embase agencée pour la fixation du support au plateau d'une machine outil à commande numérique et un moyen de fixation de l'aube sur l'embase, est caractérisé par le fait que le moyen de fixation comprend un mors fixe solidaire de l'embase et un mors libre, le mors fixe présentant une surface d'appui apte à recevoir la pale de ladite aube et qui est conformée au profil théorique de ladite pale.

Le support présente en particulier les caractéristiques suivantes, prises seules ou en combinaison :

- Les surfaces usinées du BF son t de préférence parallèles à l'axe de l'outil d'usinage tel qu'une broche. Dans le cas d'une machine à commande numérique à cinq axes, ceci permet d'éviter les erreurs de positionnement des axes rotatifs (c'est-à-dire les 4ème et 5ème axes) de la machine.
- Le support est conformé de manière à ménager une zone libre d'usinage le long du bord de fuite de la pale.
- Le support est conformé de manière à ménager une zone libre d'usinage le long et de part et d'autre du bord de fuite de la pale.
- Le support comprend des moyens de guidage en translation du mors libre.
- Le support comprend des moyens de serrage du mors libre sur le mors fixe avec interposition d'une pale, aptes à redresser la pale de l'aube, lorsque celle-ci comprend des déformations telles que de flambage.

- Le support présente une butée parallèle à l'axe du profil théorique de la pale, apte à recevoir en appui la plateforme de pied d'aube.

Le présent document décrit également un support d'un secteur de distributeur de turbomachine.

Le support d'usinage d'un secteur de distributeur de turbomachine obtenu par coulée de métal avec une pluralité de pales solidaires à une extrémité d'une plateforme intérieure et à l'autre extrémité d'une plateforme extérieure, comprenant une embase avec une face plane agencée pour la fixation du support au plateau d'une machine outil à commande numérique et un moyen de fixation du secteur de distributeur sur l'embase, est caractérisé par le fait que le moyen de fixation est agencé pour que les zones des bords de fuite des pales qui sont à usiner sont orientées perpendiculairement à ladite face plane.

Le support présente en particulier les caractéristiques suivantes prises seules ou en combinaison :

- Le moyen de fixation comprend un appui de la plateforme intérieure à l'embase et un appui de la plateforme extérieure à l'embase.
- Le moyen de fixation comprend une bride d'immobilisation de la plateforme extérieure sur son appui, selon les trois axes principaux du secteur de distributeur.
- Le moyen de fixation comprend des brides d'immobilisation de la plateforme intérieure en appui sur l'embase, avec immobilisation en rotation autour des trois axes principaux du secteur de distributeur.
- Le support comprend des moyens d'amortissement des vibrations.
- Les moyens d'amortissement des vibrations comprennent au moins un étrier solidaire de l'embase et avec des surfaces d'appui contre les deux faces opposées d'une plateforme, notamment la plateforme extérieure.
- Le support comprend deux étriers d'amortissement des vibrations un de chaque côte de la bride de fixation de la plateforme.

Le présent document décrit également un dispositif de mise en oeuvre du procédé décrit ci-dessus, comprenant :

    ○ des moyens de positionnement de l'ébauche dans un repère de référence,
    ○ des moyens d'acquisition par palpage en un nombre déterminé de points $(N_i)$ sur une première face de l'ébauche, le long du bord de fuite, de la position desdits points dans le repère de référence,
    ○ des moyens de détermination des écarts de position $delta(N_i)$ selon une direction avec les points correspondants du modèle théorique,
    ○ des moyens d'élaboration de carreaux d'usinage sur ladite face de l'ébauche, les sommets des carreaux étant déterminés à partir desdits points (Ni),
∘ des moyens de détermination de la quantité de matière à enlever à la surface des carreaux, celle-ci étant une fonction de la position des points (Nc) du carreau par rapport aux sommets des carreaux et desdits écarts de position, et
∘ des moyens d'usinage de la pale

caractérisé en ce que les moyens de positionnement comprennent un support amovible comprenant une embase de fixation au plateau de la machine outil et soit un mors solidaire de l'embase au profil théorique d'une face de la pale d'une aube mobile de turbine à usiner, soit un moyen de fixation isostatique d'un secteur de distributeur à usiner sur l'embase.

Brève description des figures

L'invention sera mieux comprise et d'autres buts et détails, caractéristiques et avantages de celle-ci apparaîtront plus clairement avec la description explicative détaillée qui suit d'un mode de réalisation de l'invention donné à titre d'exemple purement illustratif et non limitatif, en référence aux dessins schématiques annexés, sur lesquels

La figure 1 représente une aube de turbine ;
La figure 2 représente un secteur de distributeur de turbine ;
La figure 3 représente un secteur de distributeur monté sur un support amovible avec indication des points constituant les carreaux d'usinage définissant la zone de correction adaptative en bord de fuite ;
La figure 4 illustre comment le calcul de la position de l'outil d'usinage est déterminé ;
La figure 5 montre l'outil d'usinage en action le long du bord fuite d'une pale ;
La figure 6 montre un support pour aube isolée, mobile ;
La figure 7 montre le support de la figure 6 avec une aube entre les mors ainsi que la tige et la bille du palpeur à différentes positions de palpage ;
La figure 8 montre le support pour secteur de distributeur de turbine.

Description détaillée de l'invention

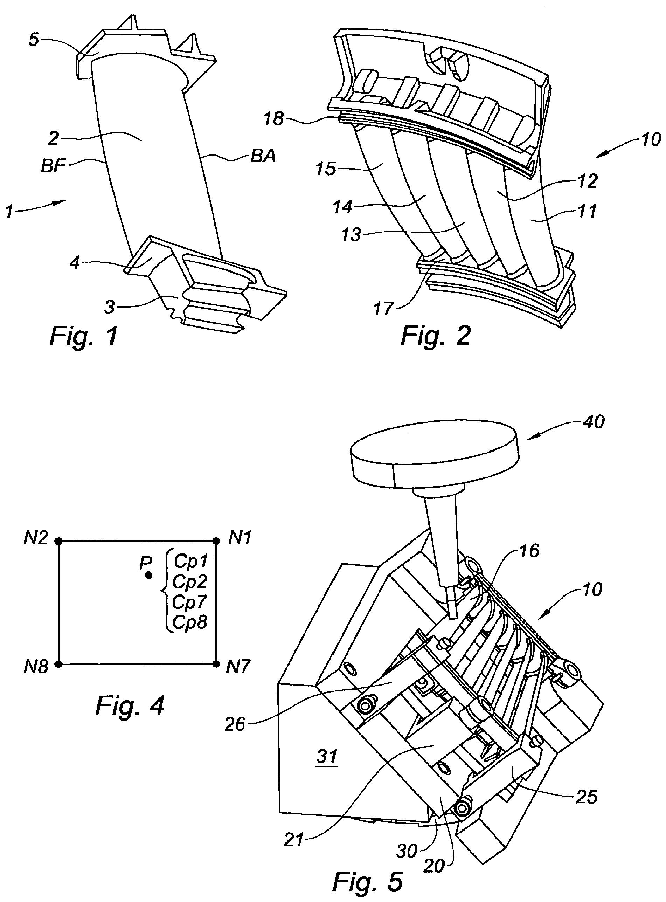

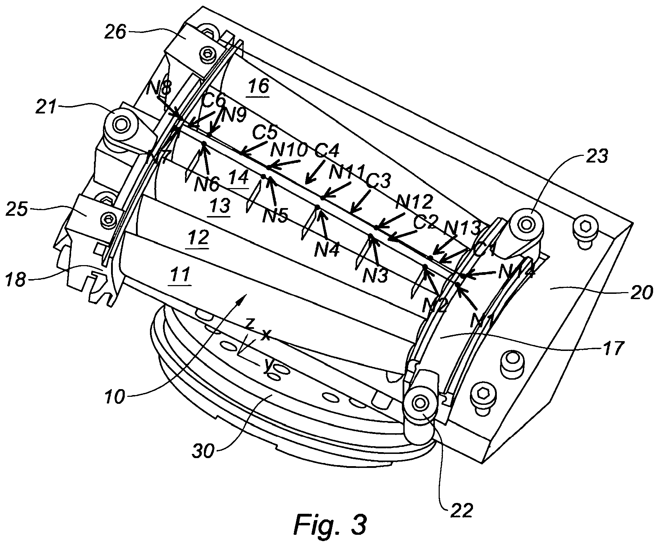

La figure 1 montre une aube 1 de turbine basse pression vue du côté de son extrados. S'agissant d'une aube mobile, celle-ci est individuelle et comprend un pied 3 par lequel elle est montée sur un rotor de turbine, une plateforme 4 entre le pied 3 et la pale 2. Une seconde plateforme 5 est formée au sommet de l'aube 1. La pale 2 s'étend, entre les deux plateformes également le long de sa corde entre le bord d'attaque BA et le bord de fuite BF plus fin. L'axe de rotation du rotor de turbine sur lequel l'aube est montée est parallèle à l'axe du pied de l'aube.
La figure 2 montre un secteur 10 de distributeur de turbine basse pression, monobloc, obtenu par coulée de métal. Ce secteur comprend une pluralité de pales 11 à 15 disposées rayonnantes en secteur de disque entre une plateforme intérieure 17 et une plateforme extérieure 18 toutes deux en arc de cercle. Un tel secteur 10 de distributeur à basse pression, comme les aubes mobile basse pression, est fabriqué selon la technique de fonderie à la cire perdue connue en soi. Malgré la précision obtenue, cette technique ne permet pas d'atteindre les faibles épaisseurs requises au niveau des bords de fuite. Un usinage est donc nécessaire. L'invention fournit un procédé permettant de réaliser une telle finition, en tenant compte des déformations de la pale.
On décrit le procédé appliqué à la finition des pales 11 à 16 d'un secteur de distributeur 10 monobloc à six pales. Celui-ci est d'abord monté sur un support amovible 20 comme on le voit sur la figure 3. Il s'agit d'un montage isostatique selon les trois axes d'un trièdre rectangle, notamment du trièdre de référence du secteur avec un maintien en translation selon les trois axes du trièdre de référence, par la bride 21 disposée du côté de la plateforme extérieure 18 au centre de celle-ci et qui assure le calage selon les trois directions du trièdre, et trois appuis de blocage en rotation par les brides 22, 23 aux extrémités de la plateforme intérieure 17 et l'appui 24 au centre non visible sur la figure 3. Le montage comprend en outre deux étriers d'amortissement des vibrations 25 et 26 disposés de part et d'autre de la bride 21.
L'angle du plan du secteur est choisi de manière à tenir compte de celui du plan de la zone du bord de fuite par rapport à ce même plan. Il est préférable que les surfaces usinées du BF soient parallèles à l'axe de l'outil d'usinage tel qu'une broche. Dans le cas d'une machine à commande numérique à cinq axes par exemple, ceci permet d'éviter les erreurs de positionnement des axes rotatifs (c'est-à-dire les 4ème et 5ème axes) de la machine.
Le support 20 est lui-même monté sur le plateau 30 de la machine à commande numérique, non représentée, par l'intermédiaire d'un socle 31.
Une fois le support 20 monté sur le plateau de la machine outil, on procède au calage au mieux du trièdre d'usinage par rapport à la pale à usiner. Dans ce but, on effectue l'acquisition, par palpage au moyen d'un appareil approprié, de la position d'un certain nombre de points sur la pale et un logiciel approprié, par example utilisant la méthode des moindres carrés, permet de calculer les corrections à apporter au trièdre de référence du montage sur la machine d'usinage. Cette correction est réalisée à l'aide de 3 rotations autour des axes X, Y, Z et d'une translation de l'origine dans les directions X, Y, Z (axes linéaires de la machine).
Le trièdre d'usinage coïncide avec les axes principaux de la pale, 11 à 16 respectivement, à usiner. La définition du trièdre est liée à la configuration de la machine ainsi qu'à la possibilité de palper selon 3 axes (les axes de rotation étant désactivés). Le positionnement de la zone usinée de la pale parallèlement à l'axe de la broche induit que l'axe X soit l'axe radial de la pale par rapport à l'axe moteur, l'axe Z l'axe de rotation du plateau, perpendiculaire au plan du plateau, l'axe Y complétant le trièdre direct. Le plan XY est constitué de la face d'appui du plateau. Il est à noter que le calage du trièdre d'usinage doit être effectué pour chacune des pales du secteur de distributeur.

Une fois le calage effectué, on procède à l'usinage dit adaptatif du bord de fuite BF. Cette technique d'usinage est décrite dans la demande de brevet FR 11 55 424 du présent déposant.

Elle comprend l'acquisition, par palpage au moyen d'un appareil de palpage approprié avec ou sans contact, de la position d'un certain nombre de points le long du bord de fuite BF de la pale à usiner. Ces points sont ceux définis sur le modèle théorique 3D de la pale dans le logiciel CFAO. Le repère de référence est celui du trièdre d'usinage.

Ici, on mesure la position des points N2 à N6, figure 3, répartis entre la plateforme intérieure 17 et la plateforme extérieure 18 à un mm (un mm correspond à une cotation fonctionnelle sur le plan référence pour la mesure de l'épaisseur du BF) et le long du bord de fuite BF de la pale 14 ébauche à usiner. Le nombre de points est au moins de trois.

A partir de ces points dont la position a été mesurée, on définit une pluralité de points induits. L'ensemble des points de contact outils/pièce définissant l'usinage de l'intrados et de l'extrados doit être contenu dans des carreaux, on ajoute donc le point N1 et le point N7 puis les points N8 à N14. Ces derniers sont à l'intersection de la corde passant par les points palpés et le bord de fuite. Les points N1 et N7 qui sont trop près de la plateforme pour pouvoir être palpés sont obtenus par translation des points N2 et N6 adjacents. Les points N1 à N14 délimitent ainsi les sommets de carreaux d'usinage, C1 à C6.

Pour chacun des points N1 à N14, on calcule alors la valeur des écarts delta (N) entre la position mesurée ou induite et la position sur le modèle théorique. En raison du calage des axes de référence, cet écart est mesuré le long de l'axe principal X. Pour chaque carreau d'usinage et en chaque zone de contact de l'outil avec la surface de l'aube à l'intérieur des carreaux, la quantité de matière à enlever est définie d'une part par la position du contact de l'outil dans le carreau et la valeur des écarts delta(N) mesurés sur chaque sommet du carreau concerné.

On décrit plus précisément le mode de détermination de la quantité de matière à enlever par usinage en référence à l'exemple de la figure 4. Dans cet exemple, les carreaux sont des polygones à quatre côtés, ils pourraient cependant avoir un nombre de côtés différents.

Chaque point P est défini par rapport aux sommets ou noeuds du carreau dans lequel il se trouve à l'aide de quatre coefficients, dits coefficients pondérateurs CPi (i étant le numéro de référence du noeud en question). Chaque coefficient pondérateur correspond au poids dont il faut affecter le noeud correspondant pour que le point P soit le barycentre de ces quatre noeuds. En d'autres termes plus le point P est proche d'un noeud, plus le coefficient, affecté à ce noeud, est élevé et, inversement, les noeuds les plus éloignés se voient affectés d'un coefficient faible. Afin de rendre unique la définition de ces coefficients pondérateurs, ils sont réduits proportionnellement les uns aux autres pour que leur somme soit égale à 1. A titre d'exemple si le point P est au centre du carreau les quatre coefficients sont égaux à 0,25 ; s'il est proche d'un des noeuds, tel qu'on le voit sur la figure 4, le coefficient CP1 sera égal à 0,5 alors que les trois autres seront respectivement égaux à 0,35 pour CP2, 0,10 pour CP7 et 0,05 pour CP8.

Le fichier constitué par les pondérations des points P à balayer par l'outil d'usinage et par les orientations correspondantes de l'axe de l'outil est alors converti en un format compréhensible par la machine à commande numérique et chargé dans son logiciel.

L'étape suivante consiste à définir un écart de positionnement delta pour tous les points de contact entre la pièce et l'outil lors de l'usinage de finition. Pour cela le calcul de ce delta prend en compte les coefficients pondérateurs du point P calculés précédemment et les écarts delta(Ni) des noeuds du carreau dans lequel se trouve le point P. Le delta au point P, c'est-à-dire la correction à apporter au point P de la surface de la pale, est défini comme étant égal à la somme des valeurs obtenues en multipliant chaque delta d'un noeud par le coefficient pondérateur qui lui est associé.

Dans l'exemple du point P situé dans le carreau formé par les quatre noeuds N1, N2, N7 et N8, la valeur de delta(P) est égale à CP1*delta (N1) + CP2*delta (N2) + CP7*delta (N7) + CP8*delta (N8).

Plus généralement, on peut l'exprimer par la formule,

$$delta(P) = \Sigma CPi*delta(Ni)$$

pour i correspondant à l'indice des sommets des carreaux d'usinage.

Cet écart delta(P), qui s'étend selon l'axe X du trièdre d'usinage au point P, détermine la composante de la correction à appliquer aux coordonnées cartésiennes données au programme qui pilote le positionnement de l'outil lors de l'usinage de finition. Dans le cas présent, la correction est apportée selon l'axe X seul.

L'usinage s'effectue ainsi de préférence par une machine-outil à commande numérique 5 axes pour laquelle la position de l'outil est à tout instant corrigée de la valeur issue des deltas des noeuds du carreau considéré et des coefficients pondérateurs du point où se trouve ledit outil. De préférence l'usinage est effectué par fraisage en roulant ; c'est-à-dire par la paroi périphérique coupante de la fraise.

Une fois que l'on a usiné la première face pour amener sa position à celle de la surface du modèle théorique, on procède à la détermination de la correction d'usinage sur la face opposée à la première, c'est à dire ici la face intrados. On part comme dans l'extrados des points initiaux N2 à N6. Le palpeur ne pouvant pas accéder entre les pales, on corrige de la même façon que l'on a corrigée sur l'extrados. On utilise les mêmes carreaux qu'à l'extrados et seuls les points de contacts outils/pièces sont différents.

Un exemple de déroulé des opérations de fraisage des pales d'un secteur de distributeur est le suivant :

- fraisage ébauche de la corde de chaque pale, une pale après l'autre, ce fraisage vise à conserver une surépaisseur,
- fraisage ébauche de l'intrados de chaque pale, une pale après l'autre,
- fraisage semi-finition et finition de l'extrados de chaque pale, une pale après l'autre,
- fraisage finition de l'intrados de chaque pale, une pale après l'autre,
- fraisage finition de la corde de chaque pale, une pale après l'autre.

L'épaisseur enlevée lors de l'usinage d'ébauche est de l'ordre de quelques dixièmes de mm voire un quelques mm (en fonction de la surépaisseur de fonderie).

L'épaisseur enlevée lors de l'usinage de finition est de l'ordre de quelques centièmes de mm.

La valeur de la correction est de quelques dixièmes de mm.

On a représenté sur la figure 5, la position d'une fraise 40 usinant l'extrados de la pale 16 en roulant le long du bord de fuite. L'outil est monté sur un porte-outil mobile selon cinq axes par exemple.

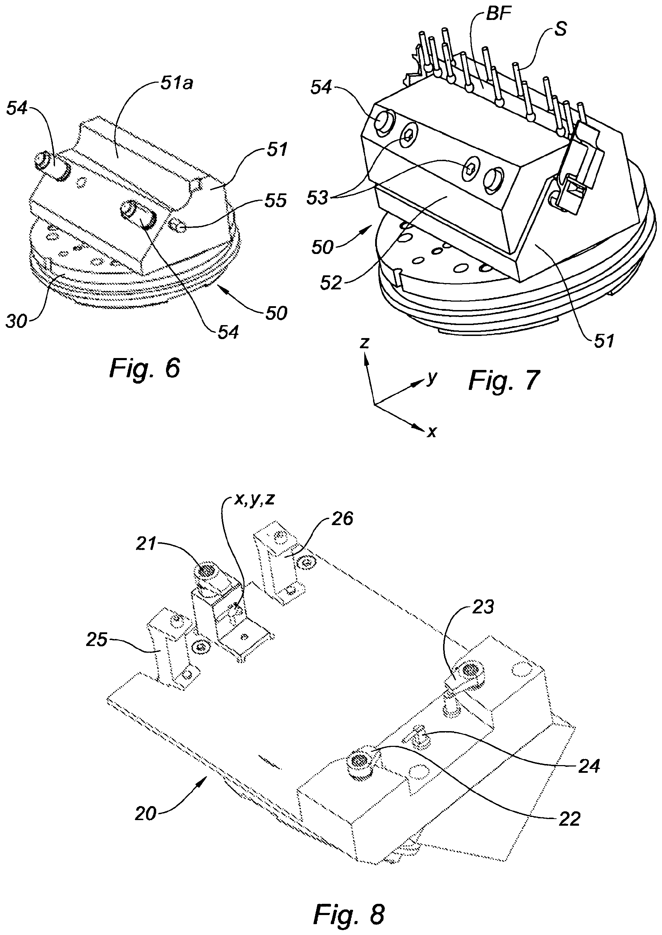

Les figures 6 et 7 montrent le montage d'une aube mobile sur un support 50. Le support comprend un mors fixe 51 dont la surface 51a de contact avec l'aube mobile est conformée de manière à recevoir l'extrados de la pale mobile. La figure 6 montre le mors fixe seul 51. Celui-ci est fixé sur le plateau 30 et présente une inclinaison déterminée. Cette inclinaison est choisie de manière à permettre l'orientation de l'outil d'usinage selon une direction telle que celle de l'axe parallèle à l'axe de la broche. La figure 7 montre l'aube mobile maintenue entre le mors 51 et un mors amovible 52 de manière à laisser libre la région du bord de fuite de la pale.

On a représenté aussi les différentes positions du palpeur S avec sa sphère au contact de la surface de la zone du bord de fuite. Le montage permet au palpeur de se positionner en chacun des points dont on souhaite mesurer la position.

Cette disposition permet à l'outil d'usiner en roulant les deux faces, intrados et extrados de la pale ainsi que la corde. Les deux mors sont serrés par les vis 53. Le déplacement de serrage du mors mobile contre le mors fixe est assuré par un guidage le long de pions de guidage 54. Les vis permettent un serrage suffisant pour réduire la déformation de la pale.

Le mors fixe 51 comprend une butée 55 pour la plateforme de pied d'aube permettant de caler l'aube en position axiale.

On procède à l'usinage de la même façon que décrite plus haut pour une pale de secteur de distributeur.

La figure 8 montre le support 20 pour secteur de distributeur sans la pièce. On voit les éléments de la fixation isostatique avec d'un côté la bride d'attache 21 pour une immobilisation dans les trois directions. De l'autre côté on voit les trois appuis pour une immobilisation en rotation autour des trois axes.

Les étriers 25 et 26 d'amortissement des vibrations sont disposés de part et d'autre de la bride 21. Ces étriers sont fixés par des vis à l'embase et comportent de coussinets d'appui venant en appui contre les faces de la plateforme empêchant la plateforme de vibrer.

## Revendications

1.  Procédé de fabrication d'une aube de turbomachine, l'aube comportant une pale disposée entre deux plateformes et le profil de la pale étant défini par un modèle théorique numérique, comprenant la fabrication d'une ébauche avec une surépaisseur ménagée sur un extrados, un intrados et une corde de la pale, le long du bord de fuite de la pale, par rapport au profil théorique, où l'on enlève ladite surépaisseur par un usinage adaptatif à l'aide d'un outil d'usinage, comprenant les étapes suivantes :

    a. Positionnement de l'ébauche dans un repère de référence,
    b. Acquisition par palpage d'au moins trois points palpés (N2 à N6) sur une première face de l'ébauche, parmi l'extrados et l'intrados, le long du bord de fuite, de la position desdits points dans le repère de référence, les points palpés (N2 à N6) étant répartis entre les plateformes à un mm du bord de fuite et étant disposés parallèlement au bord de fuite,
    c. Elaboration de carreaux d'usinage sur ladite face de l'ébauche, les sommets des carreaux étant déterminés à partir desdits points palpés (N2 à N6), l'ensemble des points de contact (P) outil d'usinage/ébauche définissant l'usinage de l'extrados et de l'intrados de l'ébauche étant contenu dans les carreaux, les sommets des carreaux d'usinage comprenant les points palpés (Ni), des points translatés non palpés (N1, N7) qui, étant trop près d'une plateforme pour pouvoir être palpés, sont obtenus par translation des points palpés adjacents (N2, N6), et des points induits (N8 à N14) qui sont à l'intersection de la corde passant par les points palpés (N2 à N6) ou translatés (N1, N7) et le bord de fuite,

d. Détermination des écarts de position delta (Ni) selon une direction avec les points correspondant du modèle théorique,

e. Détermination de la quantité de matière à enlever à la surface des carreaux, celle-ci étant une fonction de la position des points (Nc) du carreau par rapport aux sommets des carreaux et desdits écarts de position, et

f. usinage de la pale afin d'enlever la surépaisseur du bord de fuite ménagée sur l'extrados, l'intrados et la corde de la pale, la quantité de matière enlevée par usinage de la face opposée à la première face étant déterminée par la position par rapport aux sommets des carreaux d'usinage de la première face.

2. Procédé selon la revendication précédente comprenant le montage de l'aubage sur un support amovible et le montage du support amovible sur une machine outil à commande numérique avec un trièdre d'usinage, l'usinage étant effectué avec enlèvement de matière dans l'une des directions du trièdre d'usinage.

3. Procédé selon la revendication précédente, l'aubage étant une aube mobile de turbine, dont l'aubage est fixé sur le support amovible en étant serré entre un mors amovible et un mors fixe, le mors fixe étant usiné au profil théorique d'une face de la pale, laissant libre le bord de fuite à usiner.

4. Procédé selon la revendication 2, l'aubage faisant partie d'un secteur de distributeur de turbine, dont le support amovible est agencé pour un montage isostatique du secteur dans le support amovible.

5. Procédé selon la revendication précédente dont le support amovible comprend un moyen pour amortir les vibrations lors de l'usinage.

6. Procédé selon l'une des revendications 4 et 5 dont l'usinage de chacune des aubes du secteur de distributeur comprend une étape préalable de recalage au mieux de l'aube par rapport au trièdre d'usinage sur la machine outil.

**Patentansprüche**

1. Verfahren zur Herstellung einer Strömungsmaschinenschaufel, wobei die Schaufel ein Schaufelblatt umfasst, das zwischen zwei Plattformen angeordnet ist, und das Profil des Schaufelblattes durch ein digitales theoretisches Modell definiert ist, das die Herstellung einer Rohling mit einer Bearbeitungszugabe umfasst, die an einer Druckseite, einer Zugseite und einer Sehne des Schaufelblattes entlang der Abströmkante des Schaufelblattes, bezogen auf das theoretische Profil, ausgebildet ist, wobei die Bearbeitungszugabe durch eine adaptive Bearbeitung mit Hilfe eines Bearbeitungswerkzeugs entfernt wird, die die folgenden Schritte umfasst:

a. Positionieren des Rohlings in einem Bezugssystem,

b. Durch Abtasten von mindestens drei abgetasteten Punkten (N2 bis N6) auf einer ersten Seite des Rohlings aus der Druckseite und der Zugseite, entlang der Hinterkante, Erfassung der Position der Punkte in dem Bezugssystem, wobei die abgetasteten Punkte (N2 bis N6) zwischen den Plattformen in einem mm von der Hinterkante verteilt sind und parallel zur Hinterkante angeordnet sind,

c. Erstellung von Bearbeitungskästchen auf der Seite des Rohlings, wobei die Spitzen der Kästchen auf Grundlage der abgetasteten Punkte (N2 bis N6) bestimmt werden, wobei die Gesamtheit der Kontaktpunkte (P) Bearbeitungswerkzeug/Rohling, die die Bearbeitung der Druckseite und der Zugseite des Rohlings definieren, in den Kästchen beinhaltet sind, wobei die Spitzen der Bearbeitungskästchen die abgetasteten Punkte (Ni), nicht abgetastete übertragene Punkte (N1, N7), die, da sie sich zu nahe an einer Plattform befinden, um abgetastet werden zu können, durch Übertragen der angrenzenden abgetasteten Punkte (N2, N6) erhalten werden, und induzierte Punkte (N8 bis N14) umfassen, die sich am Schnittpunkt der Sehne, die durch die abgetasteten (N2 bis N6) oder übertragenen Punkte (N1, N7) und die Hinterkante verläuft, befinden,

d. Bestimmung der Positionsabweichungen Delta (Ni) in einer Richtung mit den entsprechenden Punkten des theoretischen Modells,

e. Bestimmung der Materialmenge, die an der Oberfläche der Kästchen zu entfernen ist, wobei diese von der Position der Punkte (Nc) des Kästchens bezogen auf die Gipfel der Kästchen und den Positionsabweichungen abhängig ist, und

f. Bearbeitung des Schaufelblattes, um die Bearbeitungszugabe, die an der Druckseite, der Zugseite und der Sehne des Schaufelblattes ausgebildet ist, von der Hinterkante zu entfernen, wobei die Materialmenge, die durch Bearbeitung der der ersten Seite gegenüberliegenden Seite entfernt wird, durch die Position bezogen auf die Gipfel der Bearbeitungskästchen der ersten Seite bestimmt wird.

2. Verfahren nach dem vorstehenden Anspruch, das die Montage der Beschaufelung auf einem abnehmbaren Träger und die Montage des abnehmbaren Trägers auf einer digital gesteuerten Werkzeugmaschine mit einem Bearbeitungstrieder umfasst, wobei die Bearbeitung mit Materialentfernung in einer der Richtungen des Bearbeitungstrieders durchgeführt wird.

3. Verfahren nach dem vorstehenden Anspruch, wobei die Beschaufelung eine bewegliche Turbinenschaufel ist, deren Beschaufelung auf dem abnehmbaren Träger befestigt wird, indem sie zwischen einer abnehmbaren Zunge und einer festen Zunge gespannt wird, wobei die feste Zunge mit dem theoretischen Profil einer Seite der Schaufel bearbeitet ist, wobei die zu bearbeitende Hinterkante frei bleibt.

4. Verfahren nach Anspruch 2, wobei die Beschaufelung Teil eines Turbinenverteilersektors ist, dessen abnehmbarer Träger für eine isostatische Montage des Sektors in dem abnehmbaren Träger eingerichtet ist.

5. Verfahren nach dem vorstehenden Anspruch, wobei der abnehmbare Träger ein Mittel zur Dämpfung der Schwingungen bei der Bearbeitung umfasst.

6. Verfahren nach einem der Ansprüche 4 und 5, wobei die Bearbeitung jeder der Schaufeln des Verteilersektors einen vorherigen Schritt zur bestmöglichen Neueinstellung der Schaufel bezogen auf den Bearbeitungstrieder auf der Werkzeugmaschine umfasst.

**Claims**

1. Method for manufacturing a turbine engine blade, the blade comprising a vane disposed between two platforms and the profile of the vane being defined by a theoretical digital model, involving the manufacture of a blank having a machining allowance formed on the suction face, a pressure face and a chord of the vane, along the trailing edge of the vane, with respect to the theoretical profile, wherein said machining allowance is removed by adaptive machining using a machine tool, comprising the following steps:

    a. positioning the blank in a reference frame,
    b. acquiring, by probing at least three probed points (N2 to N6) on a first face of the blank, from among the suction face and pressure face, along the trailing edge, the position of said points in the reference frame, the probed points (N2 to N6) being distributed between the platforms within one mm of the trailing edge and being disposed parallel to the trailing edge,
    c. producing machining grids on said face of the blank, the apexes of the grids being determined from said probed points (N2 to N6), the set of machining tool/blank contact points (P) defining the machining of the suction face and pressure face of the blank being contained in the grids, the apexes of the machining grids comprising the probed points (Ni), unprobed translated points (N1, N7) which, being too close to a platform to be probed, are obtained by translation of adjacent probed points (N2, N6), and induced points (N8 to N14) which are at the intersection of the chord passing through the probed points (N2 to N6) or translated points (N1, N7) and the trailing edge,
    d. determining the differences in position delta (Ni) in one direction from corresponding points on the theoretical model,
    e. determining the quantity of material to be removed from the surface of the grids, this depending on the position of the points (Nc) of the grid with respect to the apexes of the grids and said position differences, and
    f. machining the vane in order to remove the machining allowance of the trailing edge formed on the suction face, the pressure face and the chord of the vane, the quantity of material removed by machining the face opposite the first face being determined by the position with respect to the apexes of the machining grids of the first face.

2. Method according to the preceding claim comprising the mounting of the blading on a removable support and mounting the removable support on a numerically controlled machine tool having a machining axis system, the machining being performed with removal of material in one of the directions of the machining axis system.

3. Method according to the preceding claim, the blading being a rotor turbine blade, the blading of which is fixed to the removable support by being gripped between a removable jaw and a fixed jaw, the fixed jaw being machined to the theoretical profile of a face of the vane, leaving free the trailing edge to be machined.

4. Method according to claim 2, the blading forming part of a turbine nozzle sector, the removable support of which is arranged for isostatic mounting of the sector in the removable support.

5. Method according to the preceding claim, in which the removable support comprises a means for damping vibrations during machining.

6. Method according to one of claims 4 and 5, in which the machining of each of the blades of the nozzle sector comprises a prior step of best readjusting the blade with respect to the machining axis system on

the machine tool.

**Fig. 1**

**Fig. 2**

**Fig. 4**

**Fig. 5**

Fig. 3

Fig. 6

Fig. 7

Fig. 8

**EP 2 842 007 B2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2913901 A1

- FR 1155424